# EUROPÄISCHE PATENTSCHRIFT

(11) **EP 2 645 511 B1**
(45) Veröffentlichungstag und Bekanntmachung des Hinweises auf die Patenterteilung: **22.02.2017**
(21) Anmeldenummer: 13161305.1
(22) Anmeldetag: 27.03.2013
(51) Int. Cl.: H02H 3/05, G01R 31/327, H01H 83/04

(54) **Notabschalt-Überprüfung**
Emergency deactivation monitoring
Contrôle d'arrêt d'urgence

(30) Priorität: 27.03.2012 DE 102012102614
(43) Veröffentlichungstag der Anmeldung: 02.10.2013
(73) Patentinhaber: PHOENIX CONTACT GmbH & Co. KG, 32825 Blomberg (DE)
(72) Erfinder: Rohs, Markus, 32825 Blomberg (DE); Donbou Kenfouet, Celarie Marceraus, 31812 Bad Pyrmont (DE); Linke, Daniel, 32825 Blomberg (DE)
(74) Vertreter: Blumbach Zinngrebe

(56) Entgegenhaltungen:
- EP-A2- 1 983 394
- DE-A1- 19 842 059
- DE-C1- 10 059 173
- US-A1- 2004 165 404
- US-A1- 2009 251 148

## Beschreibung

Die Erfindung bezieht sich auf eine Schaltungsanordnung zur Notfallabschaltung einer Last und zum Überprüfen der Funktionstüchtigkeit der Notfallabschaltung der Last in einem System mit Sensor zur Steuerung der Last und mit Notaustaste.

Zur Notabschaltung einer Last werden mechanische oder elektronische Relais oder Schaltschütze verwendet und es gibt Anwendungen, bei denen die Sicherheit der Abschaltung äußerst bedeutsam ist. Deshalb wird in der Praxis geprüft, ob das Notschaltrelais im Notfall auch wirklich in der Lage ist, die Last abzuschalten. Diese Überprüfung erfolgt dadurch, dass das Notschaltrelais durch einen Testimpuls für eine kurze Zeit, in der Regel zwischen 300 µs und 1 ms, ausgeschaltet wird. Dieser Art der Zuverlässigkeitsprüfung haften aber Mängel an, die die Erfindung vermeiden möchte. Zwar sind elektro-mechanische Relais zu träge, um während solcher Testimpulse abzufallen, jedoch kommt es zu Schaltspielen, welche die Lebensdauer des Relais verkürzen. Bei elektronischen Relais kann es zu Fehlinterpretationen der Testimpulse führen, vor allem dann, wenn die Pulslänge der Testimpulse größenordnungsmäßig in den Bereich der Impulslänge von Nutzsignalen fällt. Bei Anlagen mit langen Kabellängen können zudem die Testimpulse durch Kabelinduktivität verzehrt oder gar verschluckt werden, so dass es zum Ausfall der Überprüfung auf Funktionalität kommt.

Aus US 2004/0165404 A1= DE 103 07 999 A1 ist eine Antriebssteuereinrichtung für einen selbstgeführten Stromrichter bekannt, der die Phasenleitungen zu einem Drehstrommotor als Last regelt. Die Antriebssteuereinrichtung umfasst eine erste und eine zweite Reihenschaltung aus jeweils einem Schalter und einer Diode, wobei Reihenschaltungen paarweise über Querverbindungen verbunden sind, um die Versorgungsspannung der Antriebssteuereinrichtung zuzuführen, damit diese Optokoppler steuern kann, die wiederum die Stromrichterventile des Stromrichters steuern. Die so ausgebildete Antriebssteuereinrichtung ermöglicht die zyklische Überprüfung der in den Reihenschaltungen liegenden Schalter ohne Betriebsunterbrechung, indem die Schalter abwechselnd ein- und ausgeschaltet werden.

Der Erfindung liegt die Aufgabe zugrunde, eine Anlage mit Notfallabschaltung einer Last dahingehend zu verbessern, dass die Überprüfung der Funktionstüchtigkeit von Schaltelementen, die insbesondere mit der Notfallabschaltung einer Last zu tun haben, während des laufenden Betriebs der Anlage schnell und sicher erfolgen kann.

Die Erfindung wird in den Ansprüchen definiert.

Im Einzelnen wird zu Zwecken der Überprüfung der Funktionstüchtigkeit von parallel angeordneten Schaltelementen im Zuge der Stromversorgung einer Last, eines dieser Schaltelemente für eine gewisse Zeitspanne eingeschaltet, während das jeweils andere, parallel geschaltete Schaltelement abgekoppelt wird und während dieser Abkoppelzeit auf Zuverlässigkeit des Abschaltens überprüft wird.

Im Falle einer Notfallabschaltung einer Last werden die regelmäßig zu überprüfenden Schaltelemente im Ausgangskreis der Anlage geöffnet. Im einzelnen wird die Notausschaltung durch zwei Reihenschaltungen aus Ausgangsschalter und zugehöriger Diode verwirklicht und ist über eine Querverbindung mit dem Hauptschalter verbunden, der die Speisespannung der Last zuführt, wenn keine Notabschaltung vorliegt. Für die beschriebenen Steuerungen ist eine Logikschaltung vorgesehen, um die Ausgangsschalter beim Testbetrieb abwechselnd für eine gewisse Zeitspanne in Betrieb zu nehmen und den jeweils außer Betrieb genommenen Ausgangsschalter auf Funktionstüchtigkeit zu überprüfen. Von besonderem Vorteil ist, dass der Ausschalter im Zuge der Stromversorgung zur Last nicht mit Testimpulsen auf Zuverlässigkeit überprüft werden braucht, was Fehlinterpretationen des Tests vermeidet.

Das Testprinzip kann auch auf andere Schaltelemente, z. B. den Hauptschalter angewendet werden. Zu diesem Zweck sind zwei zu überprüfende Schaltelemente, z. B. Hauptschalter parallel zur Verbindung mit der Speisespannung vorgesehen und können abwechselnd in Betrieb genommen werden. Die Ausgangsseiten dieser Schaltelemente oder Hauptschalter sind über Dioden entkoppelt. Das jeweils außer Betrieb gesetzte Schaltelement oder Hauptschalter kann mit der Logikschaltung auf Zuverlässigkeit überprüft werden.

Die Erfindung lässt sich auf mehrere parallele Kanäle oder Lastausgänge anwenden. Es werden jeweils zwei Ausgangsschalter einem Kanal zugeordnet, wobei ein Ausgangsschalter des Paares für eine gewisse Zeitspanne zum Betrieb des Kanals benutzt wird, während der andere, sozusagen ruhende Ausgangsschalter auf Funktionalität getestet werden kann.

Durch die Doppel- oder Mehrfachanordnung von Schaltern ist es möglich, einen Schonbetrieb der Schalter zu fahren, was deren Lebensdauer verlängert.

Ausführungsbeispiele der Erfindung werden anhand der Zeichnungen beschrieben. Dabei zeigen:
Fig. 1 eine Schaltungsanordnung zum Prüfen der Funktionstüchtigkeit einer Notfallabschaltung einer Last, Fig. 2 eine verbesserte Variante zu Fig. 1,
Fig. 3 eine Ausführungsform für eine Schaltungsanordnung mit mehreren digitalen Ausgängen,
Fig. 4 eine Schaltungsanordnung mit Masseschalter,
Fig. 5 der Masseschalter aus zwei Schaltelementen aufgebaut,
Fig. 6 eine Ausführungsvariante zu Fig. 5 für höhere Sicherheit,
Fig. 7 eine Ausführungsvariante mit mehreren digitalen Ausgängen,
Fig. 8 eine vereinfachte Schaltung bei mehreren digitalen Ausgängen, und
Fig. 9 eine Blockdarstellung des Gesamtsystems.

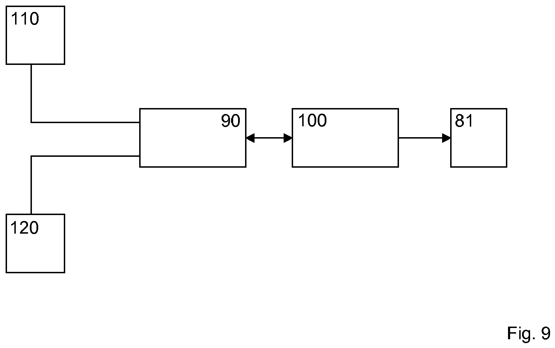

In Fig. 9 ist das Gesamtsystem mit Sensor 110 zur Steuerung einer Last 81 und mit Notaustaste 120 schematisch dargestellt. Die Last 81, kann eine Maschine, ein Gerät oder eine Schaltung, auch digitaler Art, darstellenund wird von einer Logikeinrichtung 90 gesteuert. Die Logikeinheit 90 wertet die Sensorinformationen aus und steuert die Last 81 in Abhängigkeit von diesen Sensorinformationen. Liegen die Sensorinformationen nicht innerhalb eines Sollbereichs, veranlasst die Logikeinheit die Abschaltung der Last 81 über eine Schaltungsanordnung 100 zur Notfallabschaltung.

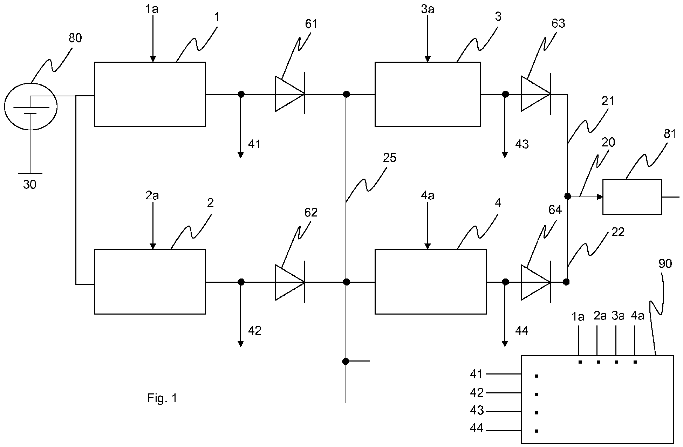

Die Abschaltung erfolgt auch aufgrund der Notaustaste 120, deren Signal von der Logikeinheit 90 ausgewertet wird. Die Schaltungsanordnung 100 zur Notfallabschaltung oder Teile davon sind in den Figuren 1 bis 8 dargestellt.

Die Schaltungsanordnung zur Notfallabschaltung nach Fig. 1 enthält einen Hauptschalter 1 und kann noch einen zweiten Hauptschalter 2 enthalten. Eine Last 81, die insbesondere eine digitale Schaltung beinhalten kann, wird von einer Stromquelle 80 über zwei Reihenschaltungen 21, 22 versorgt, die jeweils einen Ausgangschalter 3 bzw. 4 und Entkopplungsdioden 61, 63 bzw. 62, 64 enthalten und über eine Querverbindungsleitung 25 miteinander sowie mit einer Ausgangsleitung 20 verbunden sind. Die Schalter 1 bis 4 können mechanische Schaltkontakte sein, bevorzugt werden elektronische Schalter, z. B. NMOS-Transistoren. Den Schaltern 1 bis 4 sind Testabgriffe 41, 42, 43, 44 zugeordnet, die zur Logikeinheit 90 führen. Jeder Schalter 1 bis 4 verfügt über eine Ansteuerleitung, symbolisiert durch einen jeweiligen Pfeil 1a, 2a, 3a, 4a. Die Logikeinheit 90 ist mit den Schaltern 1 bis 4 über diese Ansteuerleitungen und über die Testabgriffe 41 bis 44 verbunden, um die Schalter nach Programm zu betätigen und Testspannungen von den Testabgriffen 41 bis 44 abzunehmen.

Die Überprüfung der Schalter auf Zuverlässigkeit der Notabschaltung wird wie folgt durchgeführt:
Es sei die einfache Ausstattung der Schaltungsanordnung ohne den zweiten Hauptschalter 2 angenommen. Ferner sei angenommen, dass die Last 81 über den ersten Hauptschalter 1, die Diode 61, den ersten Ausgangsschalter 3 und die Diode 63 versorgt wird. Wenn nun der Ausgangsschalter 3 auf Funktionstüchtigkeit überprüft werden soll, schaltet die Logikschaltung 90 auch den Ausgangsschalter 4 ein, sodass der Lastausgang 20 kontinuierlich mit Strom versorgt bleibt, auch wenn die Logikschaltung 90 den Ausgangsschalter 3 ausschaltet und in die Testphase überführt. In dieser Testphase ändert sich die Spannung an dem Testabgriff 43, und zwar sinkt die Spannung praktisch auf Null ab, was von der Logikschaltung 90 ausgewertet wird, um eine Aussage über die Zuverlässigkeit des Ausgangsschalters 3 abzugeben.

Wenn die Funktionstüchtigkeit des zweiten Ausgangsschalters 4 überprüft werden soll, wird der erste Ausgangsschalter 3 eingeschaltet und der zweite Ausgangsschalter 4 abgeschaltet und dabei eine Aussage über die Zuverlässigkeit der Notabschaltung gewonnen.

Die dargestellte Schaltungsanordnung mit zwei Hauptschaltern 1 und 2 lässt die Zuverlässigkeit dieser Hauptschalter in der gleichen Weise überprüfen, wie dies mit den Ausgangsschaltern 3 und 4 geschehen ist. Die Hauptschalter werden wechselweise für eine gewisse Zeitspanne in Betrieb genommen und der jeweils außer Betrieb stehende Hauptschalter wird auf Funktionstüchtigkeit getestet. Dies geschieht über die Testabgriffe 41 und 42.

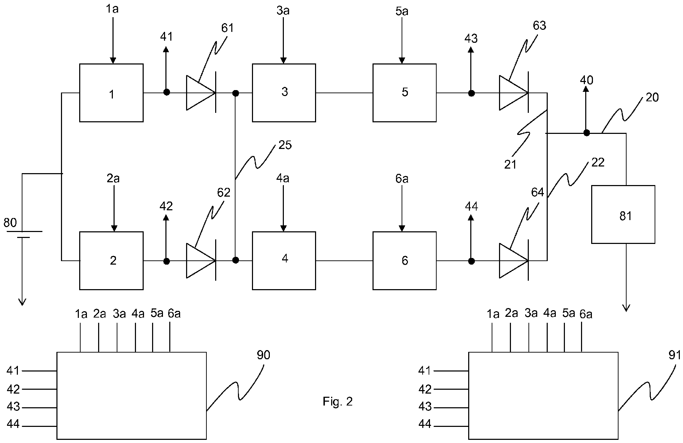

Fig. 2 zeigt eine Schaltungsanordnung zur Notfallabschaltung mit höheren Sicherheitspegeln. Zu jedem Ausgangsschalter 3 oder 4 wird ein weiterer Ausgangsschalter 5 bzw. 6 in Reihe geschaltet, zu denen Ansteuerleitungen 5a und 6a führen. Es wird für eine zweikanalige Ansteuerung mittels zweier Logikeinheiten 90 und 91 gesorgt, wenn eine Redundanz in der Ansteuerung erwünscht ist. Die Logikeinheiten können aus zwei Bausteinen unterschiedlicher, diverser Redundanz bestehen oder aber auch die gleiche Technologie aufweisen.

Die Ansteuerung der Ausgangsleitung 20 erfolgt alternativ über die Ausgangsschalter 3 und 5 oder über die Ausgangsschalter 4 und 6. Die gewissermaßen ruhenden Ausgangsschalter können während des Betriebs der anderen Ausgangsschalter diagnostiziert werden. Wenn etwa der Schalter 3 überprüft werden soll, wird der Schalter 5 eingeschaltet und die Logikschaltung spielt mit dem Schalter 3, um Prüfspannungen am Testabgriff 43 abzunehmen. Wenn der Schalter 5 überprüft werden soll, wird der Schalter 3 eingeschaltet und Schaltspiele des Schalters 5 sorgen für Prüfspannungen am Testabgriff 43. Die Schalter 4 und 6 der Reihenschaltung 22 werden in analoger Weise auf Funktionstüchtigkeit getestet. Wie schon zum Ausdruck gebracht, wird während dieser Testphase die Versorgung der Last 81 nicht unterbrochen, da eine Versorgung der Last über den jeweils nicht getesteten Zweig 21 oder 22 gewährleistet bleibt.

Die Schaltungsanordnung nach Fig. 2 ermöglicht eine zusätzliche Diagnose des Ausgangssignals über den Testabgriff 40. Durch Abschalten des Ausgangssignals der Ausgangsleitung 20 über mindestens einen der Schalter 3 oder 5 und 4 oder 6 können Haftfehler (stuck-at failure) bei einer digitalen Schaltung erkannt werden. Bei einem Haftfehler tritt Hängenbleiben auf "0" oder "1" der digitalen Schaltung auf.

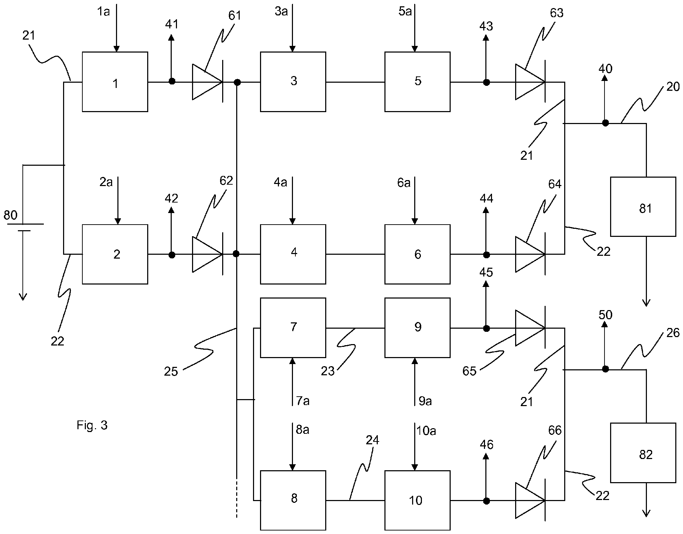

Fig. 3 zeigt eine Schaltungsanordnung mit mehreren Ausgangsleitungen 20, 26 für digitale Lasten 81, 82. Für den Ausgang 26 sind zwei zueinander parallele Reihenschaltungen aus den Schaltern 7 und 9 sowie der Diode 65 bzw. 8 und 10 und der Diode 66 vorgesehen und mit je einem Testabgriff 45 bzw. 46 versehen. Außerdem ist ein gesonderter Testabgriff 50 für den Ausgang 26 vorhanden. Zur Schaltung nach Fig. 3 gehören noch zwei Logikeinheiten wie in Fig. 2 dargestellt, jedoch mit den zusätzlichen Ansteuerleistungen 7a, 8a, 9a, 10a. Die Überprüfung auf Funktionstüchtigkeit erfolgt in der gleichen Weise, wie bei der Ausführungsform nach Fig. 2.

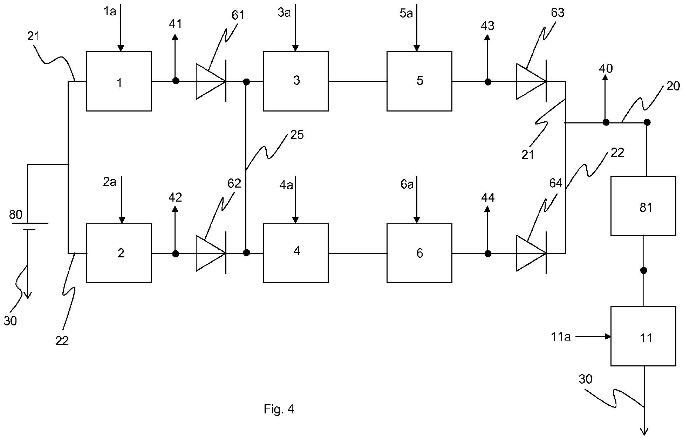

Fig. 4 zeigt die Schaltung nach Fig. 2 ergänzt mit einem Masseschalter 11, über den die Ausgangsleitung 20 zur Masse 30 weiterführt. Ein externer Haftfehler am Ausgang kann über diesen Masseschalter 11 durch Ansteuerung über die Ansteuerleitung 11a beseitigt werden, indem der Laststrom kurzzeitig abgeschaltet wird.

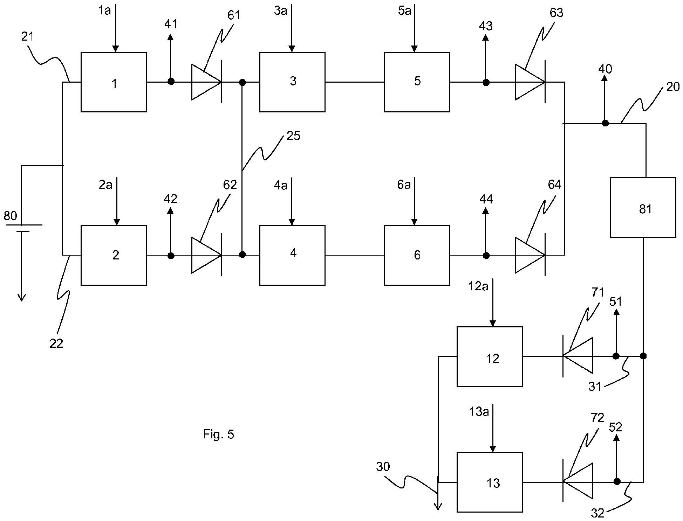

Fig. 5 zeigt eine Möglichkeit der Realisierung des Masseschalters 11, indem zwei Reihenschaltungen 31, 32 aus Schaltelement 12 und Diode 71 bzw. Schaltelement 13 und Diode 72 vorgesehen sind. Die beiden Schaltelemente 12 und 13 werden wechselseitig über Ansteuerleitungen 12a, 13a durchgeschaltet oder aber getestet, wobei die Last 81 kontinuierlich versorgt wird. Die Prüfsignale werden an den Testabgriffen 51 bzw. 52 gewonnen.

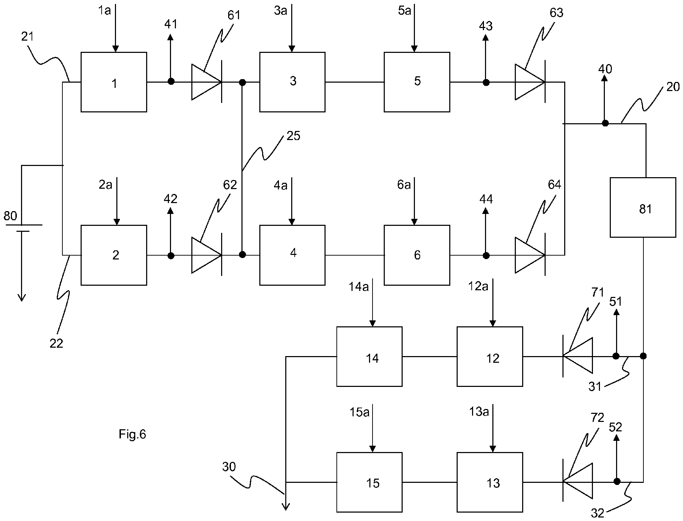

Fig. 6 zeigt eine Schaltungsanordnung zur Notfallabschaltung mit höherer Sicherheitsanforderung an den aus zwei Reihenschaltungen 31, 32 aufgebauten Masseschalter. Jede Reihenschaltung 31 bzw. 32 enthält noch ein zusätzliches Schaltelement 14 bzw. 15 mit Ansteuerleitung 14a, 15a. Ähnlich wie bei Fig. 2 beschrieben werden die Reihenschaltungen 31 oder 32 betrieben, während die Schaltelemente des gewissermaßen ruhenden Zweiges nacheinander getestet werden, indem der eine Schalter durchgeschaltet wird und der andere Schalter betätigt wird, um ein Prüfsignal am zugeordneten Testabgriff 51, 52 zu gewinnen.

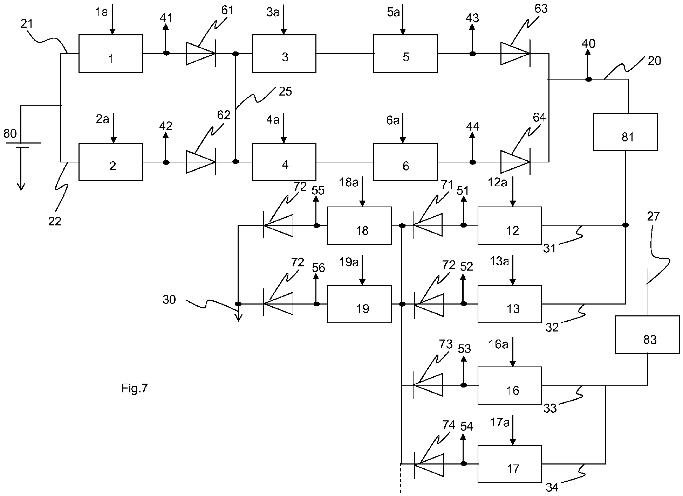

Fig. 7 zeigt ein System mit mehreren digitalen Ausgängen 20, 27, denen jeweils ein Masseschalter nach Art der Fig. 5 zugeordnet ist. Demnach gibt es außer den Reihenschaltungen 31 und 32 aus Schaltelement 12 bzw. 13 und Diode 71 bzw. 72 noch die Reihenschaltung 33 mit Schaltelement 16 und Diode 73 und die Reihenschaltung 34 mit Schaltelement 17 und Diode 74, wobei diese Reihenschaltungen 31 bis 34 und mögliche weitere Reihenschaltungen über eine Querverbindungsleitung 35 miteinander und mit wenigstens einem Hauptschalter 18 in Verbindung stehen. Im Ausführungsbeispiel sind zwei über Dioden 75, 76 entkoppelte Hauptschalter 18 und 19 dargestellt. Alle Schalter sind über entsprechende Ansteuerleitungen 1a bis 19a ansteuerbar. Die Funktionalität der Schalter kann über eine oder zwei nicht dargestellte Logikeinheiten geprüft werden, und zu diesem Zweck sind Testabgriffe 51 bis 54 für die Schaltelemente 12, 13, 16, 17 und Testabgriffe 55, 56 für die Schaltelemente 18 und 19 vorgesehen.

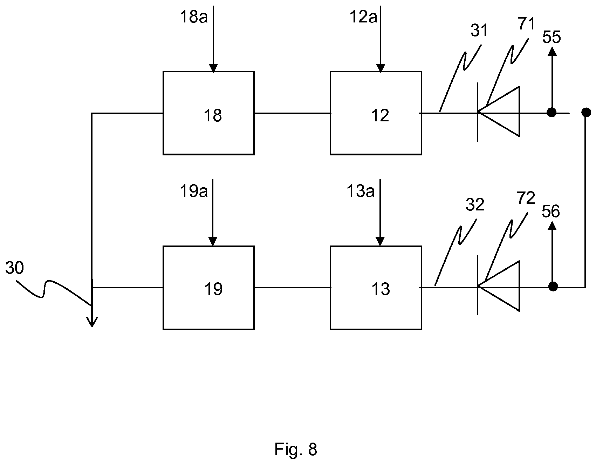

Fig. 8 zeigt eine mögliche abgewandelte Einzelheit zu Fig. 7, bei der es nur zwei zueinander parallele Reihenschaltungen 31 und 32 gibt. Das Detail ist vergleichbar mit den Reihenschaltungen 21, 22 der Fig. 2. Die Schaltelemente der Fig. 8 können in ähnlicher Weise überprüft werden wie diejenigen in Fig. 2.

Zusammenfassend kann festgestellt werden, dass durch die parallele Anordnung von Reihenschaltungen mit Schaltelementen die Schaltungsanordnung auf Zuverlässigkeit geprüft werden kann, indem eines dieser Schaltelemente außer Betrieb genommen und getestet wird, während das andere, parallel angeordnete Schaltelement den Betrieb aufrechterhält.

Um eine lange Lebensdauer der Schaltungsanordnung zu erzielen, sieht das in der Logikschaltung gespeicherte Testprogramm vor, die Schalter regelmäßig mehrmals am Tag für eine gewisse Zeitspanne umzuschalten, so dass die Betriebszeit und die Ruhezeit jedes Schalters in etwa gleich ist.

### Bezugszeichenliste:

- 1, 2: Hauptschalter
- 3 - 10: Ausgangsschalter
- 1a - 19a: Ansteuerleitung
- 11: Masseschalter
- 12 - 19: Schaltelemente
- 20, 26, 27: Ausgangsleitung
- 21,22,23,24: Reihenschaltungen
- 25, 35: Querverbindungsleitung
- 30: Masse
- 31,32,33,34: Reihenschaltungen
- 40-46, 50-56: Testabgriffe
- 61-66, 71-76: Entkopplungsdioden
- 80: Speisespannungsquelle
- 81, 82, 83: Last
- 90, 91: Logikeinheit
- 100: Schaltungsanordnung zur Notfallabschaltung
- 110: Sensor
- 120: Notaustaste

## Patentansprüche

1. Schaltungsanordnung zur Notfallabschaltung einer Last (81, 82, 83) und zum Überprüfen der Funktionstüchtigkeit der Notfallabschaltung der Last in einem System mit Sensor (110) zur Steuerung einer Last (81, 82, 83) und mit Notaustaste (120), umfassend:
- eine Speisespannungssquelle (80), die über Stromleitungen und einen Lastausgang (20) mit der Last (81, 82, 83) verbunden ist,
- einen Hauptschalter (1) zur Sperrung oder Zufuhr der Speisespannung zur Last,
- eine erste Reihenschaltung (21) aus erstem ansteuerbaren Ausgangsschalter (3) und erster Diode (63), die zu einem Lastausgang (20) führt,
- eine zweite Reihenschaltung (22) aus zweitem ansteuerbaren Ausgangsschalter (4) und zweiter Diode (64), die zu dem Lastausgang (20) führt,
- eine Querverbindung (25) zwischen den Reihenschaltungen (21, 22), um diese Ausgangsschalter (3, 4) gemeinsam an den Hauptschalter (1) anzuschließen und
- eine Logikeinheit (90) zum abwechselnden Ein- und Ausschalten jeweils eines der Ausgangsschalter (3, 4) in einem Testbetrieb bei abgekoppelter Last durch Abgriff (43, 44) der Spannung an dem jeweils überprüften Ausgangsschalter, und mit Eingeschaltet-lassen des jeweils anderen Ausgangsschalters (4, 3) in einem Lastbetrieb mit Stromzufuhr zur Last.

2. Schaltungsanordnung nach Anspruch 1, wobei ein erster und ein zweiter Hauptschalter (1, 2) an die Speisespannungsquelle (80) und an die Querverbindung (25) angeschlossen sind und mittels der Logikeinheit (90) abwechselnd in den Lastbetrieb und in den Testbetrieb gesteuert werden können.

3. Schaltungsanordnung nach Anspruch 2, wobei der erste Hauptschalter (1) über eine dritte Diode (61) mit dem ersten ansteuerbaren Ausgangsschalter (3) und mit der Querverbindung (25) verbunden ist, während der zweite Hauptschalter (2) über eine vierte Diode (62) mit dem zweiten ansteuerbaren Ausgangsschalter (4) und mit der Querverbindung (25) verbunden ist.

4. Schaltungsanordnung nach Anspruch 3,
wobei zwischen Hauptschalter (1, 2) bzw. zwischen Ausgangsschalter (3, 4) und jeweils nachgeschalteter Diode (61, 62, 63, 64) ein Testabgriff (41, 42, 43, 44) zu der Logikschaltung (90) vorgesehen ist.

5. Schaltungsanordnung nach einem der Ansprüche 1 - 4, wobei die Reihenschaltungen (21, 22) jeweils zwei hintereinander angeordneten Ausgangsschalter (3, 5; 4, 6), jeweilige Dioden (63; 64) und jeweilige Testabgriffe (43, 44) enthalten,
und wobei der Lastbetrieb entweder über die erste oder die zweite Reihenschaltung (21, 22) folgt, während der Testbetrieb mit den Ausgangsschaltern (3, 5; 4, 6) über die jeweils abgekoppelte Reihenschaltung erfolgt.

6. Schaltungsanordnung nach Anspruch 5,
wobei die jeweils hintereinander angeordneten Ausgangsschalter (3, 5; 4, 6) zweikanalig, von zwei unterschiedlichen Logikeinheiten (90, 91), ansteuerbar sind, um eine Redundanz in der Ansteuerung zu erzielen.

7. Schaltungsanordnung nach einem der Ansprüche 5 oder 6, wobei der Testbetrieb für jeweils hintereinander angeordneten Ausgangsschaltern (3, 5; 4, 6) im Einschaltzustand eines dieser Ausgangsschalter und im Schaltspielzustand des anderen Ausgangsschalters in Abhängigkeit von der Logikeinheit (90) erfolgt, die den dem Schaltspiel unterworfenen Ausgangsschalter regiert.

8. Schaltungsanordnung nach einem der Ansprüche 1 - 7, wobei mehrere Ausgangsschalter (3, 4, 7, 8) oder je zwei hintereinander geschaltete Ausgangsschalter (3/5, 4/6, 7/9, 8/10) parallel zueinander an der Querverbindung (25) angeschlossen sind und Paare bilden, die jeweils einen mit einem Lastausgang (20, 26) verbunden sind.

9. Schaltungsanordnung nach einem der Ansprüche 1 - 8, wobei der Lastausgang (20) über einen Testabgriff (40) verfügt.

10. Schaltungsanordnung nach einem der Ansprüche 1 - 9, wobei die Last (81) eine digitale Schaltung beinhaltet und mit Masse (30) über einen ansteuerbaren Masseschalter (11) verbunden ist, der Haftfehler der digitalen Schaltung zu beseitigen ermöglicht.

11. Schaltungsanordnung nach Anspruch 10,
wobei der Masseschalter (11) durch zwei parallel geschaltete, zu Masse (30) führende Reihenschaltungen (31, 32) aus Schaltelement (12, 13) und Diode (71, 72) gebildet wird.

12. Schaltungsanordnung nach Anspruch 11,
wobei jede zu Masse (30) führende Reihenschaltung (31, 32) zwei Schaltelemente (12, 14; 13, 15) enthält.

13. Schaltungsanordnung nach einem der Ansprüche 11 oder 12,
wobei jede zu Masse (30) führende Reihenschaltung (31, 32) einen Testabgriff (51, 52) enthält.

14. Schaltungsanordnung nach einem der Ansprüche 10 - 13,
wobei der Masseschalter (11) für mehrere digitale Ausgangsleitungen (20, 27) vorgesehen ist, die jeweils über Reihenschaltungen (31, 32; 33, 34) von Schaltelementen (12, 13; 16, 17) und Dioden (71, 72; 73, 74) mit wenigstens einem Hauptschalter (18; 19) verbunden sind, der die Verbindung zwischen Speisespannungsquelle (80) und Masse (30) herstellt bzw. unterbricht.

## Claims

1. A circuit arrangement for emergency shutdown of a load (81, 82, 83) and for checking the operability of the emergency shutdown of the load in a system including a sensor (110) for controlling a load (81, 82, 83) and an emergency shutdown button (120), comprising:
- a supply voltage source (80) which is connected to the load (81, 82, 83) via electrical lines and a load output (20);
- a main switch (1) for blocking or supplying the supply voltage to the load;
- a first series circuit (21) having a first controllable output switch (3) and a first diode (63) leading to a load output (20);
- a second series circuit (22) having a second controllable output switch (4) and a second diode (64) leading to the load output (20);
- a cross connection (25) between the series circuits (21, 22) for jointly connecting said output switches (3, 4) to the main switch (1);
- a logic unit (90) for alternately switching on and off a respective one of the output switches (3, 4) in a test mode with disconnected load by tapping (43, 44) the voltage at the respective output switch (4, 3) that is being tested, and with the respective other output switch (4, 3) remaining switched on in a load mode with current supply to the load.

2. The circuit arrangement according to claim 1, wherein a first and a second main switch (1, 2) are connected to the supply voltage source (80) and to the cross connection (25), which main switches can be alternately driven into the load mode and the test mode by the logic unit (90).

3. The circuit arrangement according to claim 2, wherein the first main switch (1) is connected to the first controllable output switch (3) and to the cross connection (25) via a third diode (61), while the second main switch (2) is connected to the second controllable output switch (4) and to the cross connection (25) via a fourth diode (62).

4. The circuit arrangement according to claim 3,
wherein a test tap (41, 42, 43, 44) to the logic circuit (90) is provided between the main switch (1, 2) and between the output switch (3, 4) and the respective diode (61, 62, 63, 64) connected downstream thereof.

5. The circuit arrangement according to any one of claims 1 to 4, wherein the series circuits (21, 22) each comprise two series-connected output switches (3, 5; 4, 6), a respective diode (63; 64), and a respective test tap (43, 44);
and wherein the load mode is performed either via the first or the second series circuit (21, 22), while the test mode with the output switches (3, 5; 4, 6) is performed via the respective disconnected series circuit.

6. The circuit arrangement according to claim 5, wherein the respective series-connected output switches (3, 5; 4, 6) can be controlled via two channels by two different logic units (90, 91) in order to achieve redundancy in controlling.

7. The circuit arrangement according to any one of claims 5 or 6, wherein the test mode for the respective series-connected output switches (3, 5; 4, 6) is performed in the switched-on state of one of these output switches and in the switching cycle state of the other output switch in dependence of the logic unit (90) which controls the output switch subjected to the switching cycle.

8. The circuit arrangement according to any one of claims 1 to 7, wherein a plurality of output switches (3, 4, 7, 8) or a respective pair of series-connected output switches (3/5, 4/6, 7/9, 8/10) are connected to the cross connection (25) in parallel to each other and form pairs, each of which is connected to a load output (20, 26).

9. The circuit arrangement according to any one of claims 1 to 8, wherein the load output (20) has a test tap (40).

10. The circuit arrangement according to any one of claims 1 to 9, wherein the load (81) comprises a digital circuit and is connected to ground (30) via a controllable ground switch (11) which is capable of eliminating stuck-at-faults of the digital circuit.

11. The circuit arrangement according to claim 10, wherein the ground switch (11) is defined by two parallelly connected series circuits (31, 32) of switching element (12, 13) and diode (71, 72) leading to ground (30).

12. The circuit arrangement according to claim 11,
wherein each series circuit (31, 32) leading to ground (30) comprises two switching elements (12, 14; 13, 15).

13. The circuit arrangement according to any one of claims 11 or 12, wherein each series circuit (31, 32) leading to ground (30) comprises a test tap (51, 52).

14. The circuit arrangement according to any one of claims 10 to 13, wherein the ground switch (11) is provided for a plurality of digital output lines (20, 27), each of which is connected, via series circuits (31, 32; 33, 34) of switching elements (12, 13; 16, 17) and diodes (71, 72; 73, 74), to at least one main switch (18; 19) which establishes or interrupts the connection between the supply voltage source (80) and ground (30).

## Revendications

1. Circuit d'arrêt d'urgence d'une charge (81, 82, 83) et de contrôle du bon fonctionnement de l'arrêt d'urgence de la charge dans un système comprenant un capteur (110) destiné à commander une charge (81, 82, 83) et comprenant une touche d'arrêt d'urgence (120), comportant :
- une source de tension d'alimentation (80), qui est reliée à la charge (81, 82, 83) par des lignes électriques et une sortie de charge (20),
- un commutateur principal (1) permettant le blocage ou l'amenée de la tension d'alimentation à la charge,
- un premier montage en série (21) composé d'un premier commutateur de sortie (3) pouvant être commandé et d'une première diode (63), qui mène à une sortie de charge (20),
- un deuxième montage en série (22) composé d'un deuxième commutateur de sortie (4) pouvant être commandé et d'une deuxième diode (64), qui mène à la sortie de charge (20),
- une liaison transversale (25) entre les montages en série (21, 22), afin de raccorder ces commutateurs de sortie (3, 4) conjointement au commutateur principal (1), et
- une unité logique (90) permettant la mise en service et hors service alternée de chacun des commutateurs de sortie (3, 4) en mode essai, lorsque la charge est découplée, par prise (43, 44) de la tension sur le commutateur de sortie respectivement contrôlé, et en laissant en marche chaque autre commutateur de sortie (4, 3) en mode charge avec amenée du courant à la charge.

2. Circuit selon la revendication 1, dans lequel un premier et un deuxième commutateur principal (1, 2) sont raccordés à la source de tension d'alimentation (80) et à la liaison transversale (25) et peuvent être commandés en alternance en mode charge et en mode essai au moyen de l'unité logique (90).

3. Circuit selon la revendication 2, dans lequel le premier commutateur principal (1) est relié au premier commutateur de sortie (3) pouvant être commandé et à la liaison transversale (25) par l'intermédiaire d'une troisième diode (61), tandis que le deuxième commutateur principal (2) est relié au deuxième commutateur de sortie (4) pouvant être commandé et à la liaison transversale (25) par une quatrième diode (62).

4. Circuit selon la revendication 3, dans lequel une prise d'essai (41, 42, 43, 44) par rapport au circuit logique (90) est prévue entre le commutateur principal (1, 2) ou entre le commutateur de sortie (3, 4) et la diode (61, 62, 63, 64) respectivement branchée en aval.

5. Circuit selon l'une quelconque des revendications 1 à 4, dans lequel les montages en série (21, 22) contiennent chacun deux commutateurs de sortie (3, 5 ; 4, 6) agencés l'un derrière l'autre, des diodes (63 ; 64) respectives et des prises d'essai (43, 44) respectives,
et dans lequel le mode charge est effectué par l'intermédiaire soit du premier soit du deuxième montage en série (21, 22), tandis que le mode essai est effectué au moyen des commutateurs de sortie (3, 5 ; 4, 6) par l'intermédiaire du montage en série respectivement découplé.

6. Circuit selon la revendication 5, dans lequel les commutateurs de sortie (3, 5 ; 4, 6) agencés respectivement les uns derrière les autres peuvent être commandés sur deux canaux, par deux unités logiques (90, 91) différentes, afin d'obtenir une redondance dans la commande.

7. Circuit selon l'une quelconque des revendications 5 ou 6, dans lequel le mode essai pour les commutateurs de sortie (3, 5 ; 4, 6) agencés respectivement les uns derrière les autres est effectué dans l'état de mise en service d'un de ces commutateurs de sortie et dans l'état de cycle de commutation de l'autre commutateur de sortie en fonction de l'unité logique (90), qui gouverne le commutateur de sortie soumis au cycle de commutation.

8. Circuit selon l'une quelconque des revendications 1 à 7, dans lequel plusieurs commutateurs de sortie (3, 4, 7, 8) ou respectivement deux commutateurs de sortie (3/5, 4/6, 7/9, 8/10) branchés l'un derrière l'autre sont raccordés parallèlement l'un à l'autre à la liaison transversale (25) et forment des paires, qui sont reliées chacune à une sortie de charge (20, 26).

9. Circuit selon l'une quelconque des revendications 1 à 8, dans lequel la sortie de charge (20) dispose d'une prise d'essai (40).

10. Circuit selon l'une quelconque des revendications 1 à 9, dans lequel la charge (81) contient un circuit numérique et est reliée à la masse (30) par un commutateur de masse (11) pouvant être commandé, qui permet de corriger les erreurs de collage du circuit numérique.

11. Circuit selon la revendication 10, dans lequel le commutateur de masse (11) est formé par deux montages en série (31, 32) branchés en parallèle, menant à la masse (30) et composés d'un élément de commutation (12, 13) et d'une diode (71, 72).

12. Circuit selon la revendication 11, dans lequel chaque montage en série (31, 32) menant à la masse (30) contient deux éléments de commutation (12, 14 ; 13, 15).

13. Circuit selon l'une quelconque des revendications 11 et 12, dans lequel chaque montage en série (31, 32) menant à la masse (30) contient une prise d'essai (51, 52).

14. Circuit selon l'une quelconque des revendications 10 à 13, dans lequel le commutateur de masse (11) est prévu pour plusieurs lignes de sortie numériques (20, 27), qui sont reliées chacune par des montages en série (31, 32 ; 33, 34) d'éléments de commutation (12, 13 ; 16, 17) et de diodes (71, 72 ; 73, 74) à au moins un commutateur principal (18 ; 19), qui établit ou interrompt la liaison entre la source de tension d'alimentation (80) et la masse (30).
